# EUROPÄISCHE PATENTSCHRIFT

(11) **EP 2 144 713 B1**
(45) Veröffentlichungstag und Bekanntmachung des Hinweises auf die Patenterteilung: **15.11.2017**
(21) Anmeldenummer: 08716372.1
(22) Anmeldetag: 08.03.2008
(51) Int. Cl.: B05D 7/00

(54) **VERFAHREN ZUR HERSTELLUNG VON BESCHICHTETEN TEILEN**
METHOD FOR PRODUCING COATED PARTS
PROCÉDÉ DE FABRICATION DE PIÈCES REVÊTUES

(30) Priorität: 10.03.2007 DE 102007012001
(43) Veröffentlichungstag der Anmeldung: 20.01.2010
(73) Patentinhaber: Keinath, Renate, 72336 Balingen (DE)
(72) Erfinder: Keinath, Renate, 72336 Balingen (DE)
(74) Vertreter: Reinhardt, Harry
(86) Internationale Anmeldenummer: PCT/EP2008/001860
(87) Internationale Veröffentlichungsnummer: WO 2008/110311

(56) Entgegenhaltungen:
- EP-A- 0 429 236
- JP-A- 59 109 271

## Beschreibung

Die Erfindung betrifft ein Verfahren zur Herstellung von Teilen, welches gleichzeitig in einem Herstellungsprozess sowohl das Spritzgießen wie auch eine in-line nachgeschaltete Oberflächenbehandlung betrifft, nach dem Oberbegriff des Anspruches 1.

Viele Kunststoffteile aber auch Teile aus anderen Materialien, die uns täglich begegnen, sind mit Beschichtungen versehen, um bestimmten Qualitätsstandards zu genügen. Die Veredelung, kratzfeste Versiegelung oder Beschichtung von Oberflächen an Spritzguß- und anderen Bauteilen erfolgt meist unter Reinraumbedingungen. Diese Anforderungen erfüllen meist nur speziell dafür eingerichtete Beschichtungsfirmen, zumal die Beschichtungskosten hoch im Vergleich zu den Herstellungskosten der einzelnen Bauteile sind. Dies liegt daran, dass die Beschichtungsanlagen in der Anschaffung sehr teuer sind. Daher müssen sehr viele Teile diese Anlagen durchsetzen, um eine Rentabilität zu erzielen. Dies ist für kleine und mittlere Unternehmen nicht möglich, da sie nicht den Durchsatz haben und es außerdem sehr aufwendig ist, eine Anpassung an verschiedene Bauteile durchzuführen. Dadurch besteht auch eine gewissen Abhängigkeit der Bauteilhersteller zu den Beschichtungsfirmen.

In vielen Bereichen liegen jedoch kleinere Stückzahlen als zum Beispiel im Mobilphone-Bereich vor. Ferner besteht der Wunsch einer Inline-Bearbeitung mit entsprechenden Herstellungsmaschinen, wie z.B. Kunststoff-Spritzgießmaschinen zur Verarbeitung von Kunststoffen und anderen plastifizierbaren Materialien wie pulverige, metallische oder keramische Massen.

Eine In-Line-Beschichtungsanlage ist aus "In-Line-Beschichtungsanlage zur Abscheidung optisch hochwertiger Schichtsysteme aus Kunststoff- und Aluminium-Reflektoren für die Leuchtenindustrie", I. Kaden, P. Vetters, Otec Jordan GmbH & Co. KG, Olbernhau; P. Botzler, A. Langer, H. Waydbrink, von Ardenne Anlagentechnik GmbH, Dresden, H.-U. Poll, Prof. Dr., FZM GmbH, Flöha, erschienen zu 8. Neues Dresdner Vakuumtechnisches Kolloquium, Dresden, 19/20. Oktober 2000 bekannt. Unter Vakuum können kleinere Gebinde von Reflektoren mit Aluminium im kontinuierlichen Betrieb durch Sputtering beschichtet werden. Der Inline-Betrieb wird dadurch gewährleistet, dass einer Vakuumkammer mehrere Vorkammern und nachgeschaltete Kammern zugeordnet sind, so dass ein kontinuierlicher Betrieb möglich ist. Die zu beschichtenden Teile werden auf hierfür vorgesehenen Trägern angeordnet und durch die Beschichtungsanlage geführt.

Von der SINGULUS TECHNOLOGIES AG ist eine Metallisierungsanlage "SINGULUS 3DS" zur dekorativen Beschichtung von Kunststoffteilen bekannt, in der durch Sputtering dreidimensionale Kunststoffteile im Vakuum mit schützenden und dekorativen Oberflächen versehen werden. (Pressemitteilung der SINGLUS TECHNOLOGIES AG vom 23.01.2007; http://www.singulus.de/deutsch/3 presse/index presse.htm; "Singulus 3DS", http://www.singulus.de/deutsch/4 produkte/index decorative.htm)

Aus der DE 603 03 011 T2 ist ferner die Herstellung gut haftender Beschichtungen auf einem Substrat bekannt, das nach entsprechender Vorbehandlung mit einem Photoinitiator vorbeschichtet, mit einem ethylenisch ungesättigten Monomer oder Oligomer beschichtet und die Beschichtung mittels Strahlung gehärtet wird. Dabei handelt es sich um die plasmaunterstützte Abscheidung dünner Schichten, wie dies im Stand der Technik seit längerem bekannt ist.

Im Bereich der Herstellung von CDs ist es bekannt, im festgelegten Zwangsablauf CDs herzustellen und zu verpacken. Die CDs werden dabei aus dem Spritzgießwerkzeug automatisch entnommen, an Weiterbearbeitungsstationen übergeben, in denen ein Abkühlen, Vakuumbedampfen, Bedrucken und eine Qualitätssicherung erfolgt, sowie zur weiteren Verpackung abgelegt. Hierbei handelt es sich ausschließlich um das Produkt CD, d.h. eine ebene Scheibe, so dass diese Art der Bearbeitung auf andere Anwendungen und insbesondere auf lackierte Teile nicht übertragbar ist.

Da die optischen Anforderungen an nachbehandelte Kunststoffteil-Oberflächen immer höher werden, sind in dem bisher mehrstufigen Verfahren die Qualitäten nicht mehr optimal beeinflussbar. Neben bekannten Anforderungen wie Reinraum zwecks Partikelfreiheit oder Sauberkeit trägt die Qualität des Teils, nämlich des Kunststoffspritzteiles, welches direkt aus dem Fertigungsprozess kommt, wesentlich zur Oberflächenqualität bei.

Ausgehend von diesem Stand der Technik, nämlich der Batch-Fertigung liegt der vorliegenden Erfindung die Aufgabe zugrunde, ein Verfahren für einen Gesamtprozessablauf zur Herstellung von Beschichtungen auf Spritzgießteilen zu schaffen.

Diese Aufgabe wird durch ein Verfahren mit den Merkmalen des Anspruches 1 gelöst.

In dem Gesamtprozess erfolgt eine Spritzteilherstellung aus Kunststoff oder ähnlichen plastifizierbaren Materialien wie pulverige, metallische oder keramische Massen, eine vorzugsweise gezielte Teileentnahme mit lagedefiniertem Transport sowie vorzugsweise unter Reinraumumgebung ein direkt nachgeschalteter Oberflächenbehandlungs-Prozess, wobei zur Prozessoptimierung eine gegenseitige Beeinflussung und Regelung der Spritzgießmaschine und der Beschichtungseinrichtung erfolgt. Damit ergibt sich ein Gesamtprozess mit dem Ziel, höchste Qualität mit minimalstem Ausschuss und somit höchster Präzision und Kostenminimierung zu realisieren.

Gleichzeitig lassen sich sehr flexibel auch kleinere Chargen von beschichteten, z.B. lackierten, insbesondere dreidimensionalen Teilen abarbeiten. Die Beschichtung kann z.B. in Vakuumkammern oder in einem unter Überdruck gesetzten Raum aufgebracht werden. Dies ist unabhängig von der Form, Geometrie oder Größe des Teils möglich. Das heißt, beliebige auch dreidimensionale Teile können beschichtet werden, ggf. muss lediglich die Größe der Einrichtung an das Teil angepasst werden.

Bedarfsweise ist insbesondere, aber nicht nur bei einer Ausgestaltung mit entsprechenden vorgeschalteten und nachgeschalteten Kammern eine kontinuierliche Herstellung im Inline-Betrieb möglich. Durch die vor allem beim Inline-Betrieb mögliche Zwangsläufigkeit im Zyklus einer Spritzgießmaschine werden kurze Durchlauf- und Fertigungszeiten erreicht, was wiederum hohe und schnelle Verfügbarkeit bedeutet. Damit kann die Anlage auch flexibel kleinere Losgrößen wirtschaftlich herstellen.

Bei der Inline-Herstellung können Teile unmittelbar aus der Spritzgießmaschine entnommen und in die Einrichtung zur Beschichtung übergeben werden. Da der Prozess z.B. unter Vakuum abläuft, sind Verschmutzungen bereits reduziert. Da zudem die Teile nach dem First-in First-out (FiFo)-Prinzip abgearbeitet werden können, ist eine mögliche Verschmutzung deutlich verringert, zumal eine unmittelbare Übergabe aus der Maschine in die Einrichtung erfolgen kann. Dies ist auch eine wichtige Voraussetzung für die Weiterverarbeitung, d.h. der gesamte Prozess kann bedarfsweise weitestgehend, muss jedoch nicht zwingend unter Reinraum- bzw. reinen Raumbedingungen ablaufen. Wenn erwünscht, ist auch ein Betrieb der Einrichtung ggf. einschließlich der zugeordneten Spritzgießmaschine in einer Umhausung mit Überdruck möglich, um einem Eindringen von Fremdkörpern vorzubeugen. Damit können auch die Anforderungen an Sichtteile, die optisch bewertet werden, eingehalten werden.

Weitere Vorteile ergeben sich aus den Unteransprüchen und der nachfolgenden Beschreibung.

Im Folgenden wird die Erfindung an Hand von in den beigefügten Figuren dargestellten Ausführungsbeispielen näher erläutert. Es zeigen:
Fig. 1 eine schematische Darstellung einer Einrichtung zur Herstellung von Beschichtungen im Inline-Betrieb gemäß Fig. 1 in Verbindung mit einer Spritzgießmaschine mit zugehörigen Steuerungen,
Fig. 2 eine Draufsicht auf eine weitere Einrichtung zur Herstellung von Beschichtungen, die einer Spritzgießmaschine zugeordnet ist.

Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

Die Figuren zeigen Einrichtungen, in denen ein Verfahren zur Herstellung von beschichteten Teilen 10, wie einem beliebigen Kunststoffteil oder auch einem Teil aus anderen Materialien durchgeführt werden kann. Die Teile werden in einer Spritzgießmaschine 15 zur Verarbeitung von Kunststoffen und anderer plastifizierbarer Materialien wie pulverige, metallische oder keramische Massen hergestellt und aus der Spritzgießmaschine 15 zur Weiterverarbeitung in einer Einrichtung zur Oberflächenbeschichtung vorzugsweise lagerichtig entnommen. Die Beschichtung ist vorzugsweise eine Lackbeschichtung kann jedoch auch eine andere Beschichtung sein. Lack ist ein flüssiger oder auch pulverförmiger Beschichtungsstoff, der dünn auf Gegenstände aufgetragen wird und durch chemische oder physikalische Vorgänge (zum Beispiel Verdampfen eines Lösemittels) zu einem durchgehenden Film aufgebaut wird.

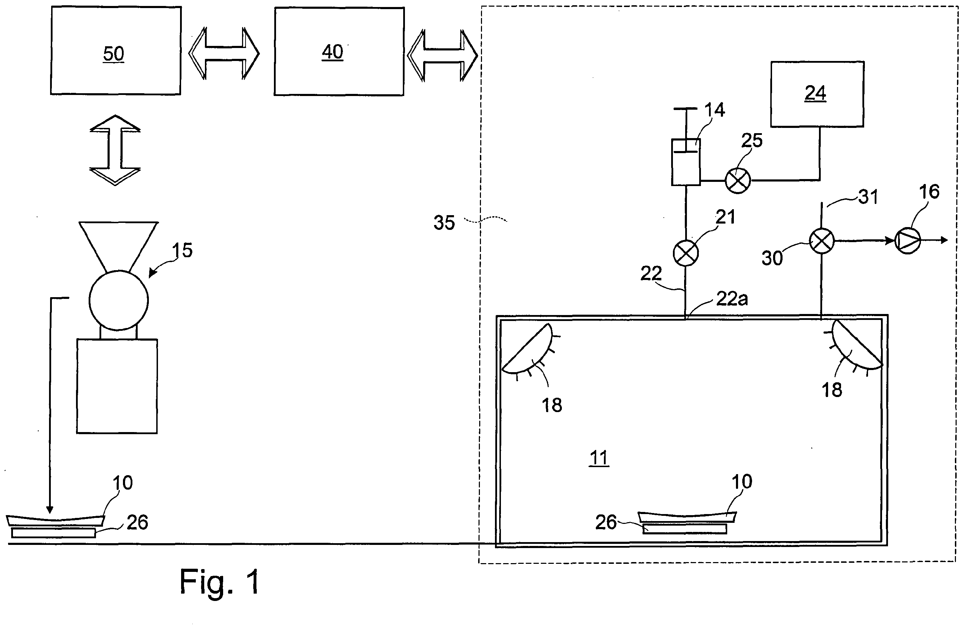

Das Ausführungsbeispiel der Fig. 1 zeigt als Einrichtung für die Oberflächenbeschichtung eine Vakuumkammer 11, die über eine bedarfsweise mittels Ventil 30 zuschaltbare Vakuumpumpe 16 evakuiert werden kann. Alternativ kann auch mit Überdruck in einer geeigneten Umhausung gearbeitet werden. Entsprechende Vorrichtungen zur Aufbringung der Beschichtung wie z.B. eines Lacks sind ebenso vorgesehen wie Aushärtemittel 18 zum Aushärten der Beschichtung ggf. in weiteren Kammern. Ferner sind Mittel zum Einbringen des Teils in und zum Entnehmen des Teils aus der Vakuumkammer 11 vorgesehen, die im Ausführungsbeispiel der Figur 1 nicht dargestellt sind, jedoch in Form eines bekannten Handlings vorgesehen sein können.

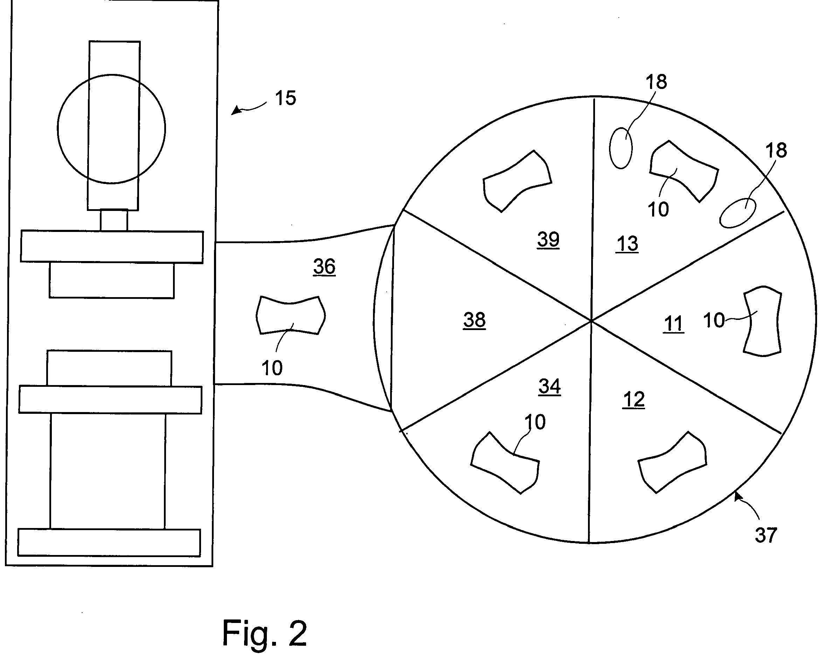

Gemäß Fig. 2 können die einzelnen Schritte und die dafür erforderlichen Elemente auch räumlich im selben Behälter z.B. auf einem vorzugsweise im Taktzyklus der Spritzgießmaschine getaktet betriebenen Drehtisch 37 angeordnet werden, in dem ausgehend von einem Übergabebereich 36 zwischen der Substrat-Herstellungsmaschine 15 und dem Drehtisch 37 die Teile über eine Übergabestation 38 in die Vakuumkammer 11 eingebracht werden. Der Vakuumkammer 11 können, müssen jedoch nicht wenigstens eine Eingangskammer 12 vorgeschaltet und wenigstens eine Ausgangskammer 13 nachgeschaltet sein. Das fertig beschichtete Teil kann anschließend in einer Entnahmestation 39 entnommen werden. Eine der Kammern, im Ausführungsbeispiel die Konditionierungskammer 34 kann auch dafür vorgesehen sein, die Substrate vor dem Einbringen in die Vakuumkammer zu konditionieren, d.h., es können z.B. Wärmestrahler und/oder Ventilatoren vorgesehen sein, um die Oberflächentemperatur der Teile in einen bestimmten Temperaturbereich zu bringen oder zu halten. Die Temperatur kann z.B. durch kontaktlose Temperaturfühler erfasst werden oder mittelbar durch die Temperatur in der Konditionierungskammer 34 bestimmt werden bzw. aus dem Spritzgießprozess abgeleitet beeinflusst werden. Die Schritte ggf. Konditionieren, Einbringen, ggf. stufenweises Evakuieren, Beschichten, Aushärten und Entnehmen erfolgen so nacheinander in verschiedenen Stationen des Drehtischs.

Der Vakuumkammer zugeordnet und in Figur 1 in der Ausgangskammer angeordnet ist das Aushärtemittel 18. Als Aushärtemittel 18 kommen z.B. UV-Strahlungsquellen oder Wärmequellen in Betracht. Bedarfsweise kann die erforderlich Menge an Beschichtungsmaterial über Dosierbehälter 14 mit unterschiedlichen Mengen dosiert werden, wobei die dosierte Menge über die Steuerung 40 einstellbar ist und ggf. vom Spritzgießprozess abhängig beeinflusst werden kann.

Fig. 1 zeigt ein Ausführungsbeispiel, das für eine In-Line-Lackieranlage eingesetzt werden kann. Der Einrichtung zugeordnet ist zunächst eine Spritzgießmaschine 15, ein Extruder oder eine andere Kunststoff verarbeitende Maschine. Das Teil 10 gelangt aus der Spritzgießmaschine 15 in Fig. 1 links auf den Träger 26 und kann dann durch die Kammern über bekannte Transportmittel hindurchgeführt werden, bis das fertig lackierte Teil in Figur 1 rechts aus der Einrichtung gelangt. In ähnlicher Weise kann das Teil 10 in Fig. 2 aus dem Übergangsbereich kommend nacheinander die Kammern durchlaufen, um dann z.B. an der Entnahmestation 39 entnommen zu werden. Vorzugsweise gelangen die Teile 10 nach dem FiFo-Prinzip aus der Spritzgießmaschine 15 und bleiben weitestgehend unter Reinraumbedingungen. Die Teile können dann inline einzeln oder gruppenweise nacheinander die Vakuumkammer durchsetzen.

Im Ausführungsbeispiel der Fig. 2 umfasst die Vakuumkammer 11 zusätzlich eine Eingangskammer 12 und eine Ausgangskammer 13, so dass ein kontinuierlicher Prozess unter Vakuum möglich ist. Die Eingangs- und Ausgangskammern sind schleusenartig mit der Vakuumkammer 11 verbunden, so dass bereits in der Eingangskammer und auch in der Ausgangskammer noch bedarfsweise ein Vakuum aufrechterhalten werden kann. Bedarfsweise können auch weitere Kammern auf beiden Seiten vorgesehen werden, wenn der Prozess oder weitere Prozessschritte dies erforderlich machen. Ebenso kann aber auch nur mit einer Vakuumkammer bzw. Kammer gearbeitet werden. Im Ausführungsbeispiel ist eine Konditionierungskammer 34 der Vakuumkammer vor geschaltet. In dieser Kammer können Mittel vorgesehen sein, um die Teile auf einheitliche Bedingungen wie z.B. Oberfächenbeschaffenheit oder -temperatur für die weitere Beschichtung zu bringen. In der Vakuumkammer 11 erfolgt die Beschichtung. Das Aushärtemittel 18 ist im Ausführungsbeispiel der Fig. 2 der Ausgangskammer 13 zugeordnet.

Bedarfsweise sind auch Mehrfachlackierungen möglich. Dazu kann entweder in einer Kammer nacheinander aus verschiedenen Dosierbehältern das Teil beschichtet werden oder es können auch Kammern aneinandergesetzt werden. So kann z.B. eine Handyschale als Teil in einer ersten Kammer mit einer Grundfarbe beschichtet werden, in einer weiteren Kammer kann dann z.B. ein Inlay oder ein Abdeckteil aufgebracht werden und dann die nächste Farbe aufgebracht werden, usw. Ebenso können in einer gemeinsam zu bearbeitenden Charge in der Folge zusammengehörige Teile gemeinsam beschichtet werden, wie z.B. das Ober- und Unterteil einer Handyschale.

Die in Figur 1 dargestellte Vorrichtung arbeitet folgendermaßen:
Zunächst wird das von der Spritzgießmaschine 15 kommende Teil 10 auf dem Träger 26 in die Vakuumkammer 11 gebracht. Die Vakuumkammer wird dann über die Vakuumpumpe 16 unter Vakuum gesetzt. Eine Beschichtung wie z.B. Lack wird aus dem Lackbehälter 24 bei geöffnetem Ventil 25 in den Dosierbehälter 14 überführt. Nach Öffnen des Ventils 21 gelangt der Lack über die Leitung 22 und die Eintrittsöffnung 22a in die Beschichtungskammer, die vorzugsweise eine Vakuumkammer 11 ist. Sind mehrere Dosierbehälter 14 vorhanden, können auch mehrere Leitungen 22 z.B. entsprechend der Anzahl der Dosierbehälter vorgesehen sein. Das Ventil 21 wird wieder verschlossen und nun härten die Aushärtemittel 18 wie z.B. Wärmestrahler oder UV-Strahler die Beschichtung auf dem Teil 10 aus. An den z.B. der Vakuumpumpe 16 zugeordneten Ventilen 30, die die Atmosphäre in der Vakuumkammer über die Belüftungsleitung 31 wieder zuschalten, können ergänzend zeichnerisch nicht dargestellte Filter vorgesehen sein, um beim Belüften die Zuluft zu filtern.

Bei der Herstellung wird das Teil 10 aus Kunststoffmaterial oder ähnlichen Materialien unter Reinraumbedingungen spritzgegossen, wobei die Reinraumbedingungen zumindest auf der Werkzeugschließseite vorliegen sollten. Damit wird verhindert, dass Staubpartikel über das Werkzeug in die Oberfläche eindringen können bzw. nach der Entformung eine Kontamination entsteht. Anschließend erfolgt eine Zwangsentnahme durch Robotsysteme und ein weiterer Transport vorzugsweise unter Reinraumbedingungen, z.B. zu einer Zwischenspeicherung mit dem Ziel der Abkühlung, des Temperierens und des Konditionierens der Teile. Durch diesen Zwischenspeicher wird eine zeitliche Zwangsfolge und somit Konstanz für die Prozessbedingungen der Weiterverarbeitung festgelegt. Hier kann es auch von Vorteil sein, wenn das Teil 10 beim Eintritt in die Vakuumkammer noch eine bestimmte Mindesttemperatur aufweist, d.h. die Energie genutzt wird, die dem Teil aus der Spritzgießmaschine mitgegeben worden ist.

Der Weitertransport der Teile erfolgt durch Robotsysteme bis zur nächsten Station, z.B. der Einrichtung zur Herstellung der Beschichtung. Alternativ sind Inline-Oberflächenbehandlungen, Laser-Behandlungen oder ein Inline-Besprühen möglich. Durch den lagegerechten Weitertransport ist eine genaue Positionierung gegeben, was wiederum eine Voraussetzung für eine exakte Weiterverarbeitung im 3-D-Bereich ist. Nach dem Aushärten können noch weitere Stationen z.B. zum Bedrucken mit Symbolen oder Lasern von behandelten Oberflächen vorgesehen werden. Ziel kann sein, Markierungen an der Oberfläche durch Herauslösen des zusätzlichen Auftrags zu erreichen. Am Ende des Herstellungsprozess kann ein Palettieren bzw. Stapeln gegebenenfalls auch unter Reinraumbedingungen erfolgen. Durch die Zwangsläufigkeit werden kurze Durchlauf- und Fertigungszeiten erreicht, was wiederum hohe und schnelle Verfügbarkeit bedeutet. Damit kann die Anlage auch flexibel kleinere Losgrößen wirtschaftlich herstellen.

Figur 2 zeigt die Verknüpfung der Spritzgießmaschine am Beispiel eines Verfahrens, welches gleichzeitig in einem Herstellungsprozess sowohl das Spritzgießen wie auch ein in-line nachgeschaltete Oberflächenbehandlung betrifft.

Da z.B. die optischen Anforderungen an nachbehandelte Kunststoffteil-Oberflächen immer höher werden, sind in dem heute mehrstufigen Verfahren die Qualitäten nicht mehr optimal beeinflussbar. Neben bekannten Anforderungen wie Reinraum zwecks Partikelfreiheit oder Sauberkeit trägt vor allem die Qualität des Teils, also im Beispiel die des Kunststoffspritzteils, welches direkt aus dem Fertigungsprozess kommt, wesentlich zur Oberflächenqualität bei. Genau dies lässt sich nun aber nutzen, wenn die Steuerung 40, die den Einflussbereich 35 der Einrichtung zur Beschichtung steuert mit der Steuerung 50 der Spritzgießmaschine zur gegenseitigen Regelung verknüpft werden, was durch die Pfeile angedeutet ist. Damit wird ein Gesamtprozessablauf geschaffen, in dem folgende Schritte enthalten sein können:
- Herstellung des Teils 10 z.B. durch Spritzgießen aus Kunststoff oder ähnlichen Materialien,
- gezielte Teileentnahme mit lagedefiniertem Transport,
- gleichzeitige Kühlung und Konditionierung der Teile bzw. ihrer Oberfläche,
- Reinraumumgebung und direkt nachgeschalteter Oberflächenbehandlungs-Prozess

Für die Qualität der Beschichtung ist im Beispiel des Spritzgießprozess die Oberflächenqualität des Spritzteiles von Bedeutung, die im Wesentlichen durch Prozessparameter der Spritzgießmaschine wie Massetemperatur, Einspritzgeschwindigkeit, Einspritzdruck und Kühlzeit bestimmt wird.

In Verbindung mit der Kühlzeit des Teils in der Spritzgießmaschine kann z. B. durch die Werkzeugtemperatur Einfluss auf die Oberflächentemperatur der gespritzten Teile genommen werden. Die Oberflächentemperatur ist wiederum entscheidend für den Beschichtungsprozess, welcher ihrerseits für die Haftung, die Glanzqualität und die Oberflächenstruktur der Beschichtung maßgeblich ist. Da die Steuerung 50 der Spritzgießmaschine diese wesentlichen Parameter kennt bzw. durch Sensorik feststellen kann, können diese Daten der Steuerung 50 der Spritzgießmaschine für die Steuerung 40 der inline angeordneten Beschichtungs- bzw. Lackiereinrichtung herangezogen werden.

Z. B. kann das Teil in Kenntnis seiner Oberflächentemperatur durch Verzögerung in der Kühlstrecke prozessgesteuert gleichmäßig dem Beschichtungsprozess zugeführt werden, so dass sich gleichmäßigere Ergebnisse ausbilden. Umgekehrt kann durch entsprechende Messsensorik nach dem Beschichtungsprozess die Oberflächenqualität, die Oberflächenbeschaffenheit, der Glanz oder ähnliche aussagekräftige Messgrößen des fertigen Teils gemessen werden und diese im Regelkreis zur Parameteroptimierung an der Spritzgießmaschine regulierend verwendet werden, d.h. dass z.B. die Zykluszeit zwecks Anpassung der Oberflächentemperatur angepasst oder der Werkzeuginnendruck erhöht wird, um eine bessere Oberflächenbeschaffenheit zu erhalten.

In der Konditionierungskammer 34 kann in Abhängigkeit der erfassten Parameter aus dem Spritzgießprozess oder aus dem Beschichtungsprozess das Teil konditioniert werden, indem z.B. ein geregelter Kühl- oder Heizprozess erfolgt, um weitestgehend einheitliche Parameterbereiche der Teile vor der Beschichtung zu erhalten oder aufrechtzuerhalten. Insofern sind sowohl die Parameter aus dem Spritzgießprozess maßgeblich für die eingebrachten Teile als auch die Ergebnisse aus dem Beschichtungsprozess wie Glanz oder Oberflächenqualität relevant für die Regelung der Parameter in den Prozessen als auch für die Regelung der Beeinflussung durch die Konditionierungskammer 34. In der Konditionierungskammer 34 können z.B. Wärmestrahler und/oder Ventilatoren vorgesehen sein, um die Oberflächentemperatur der Teile bedarfsweise zu erhöhen oder zu verringern. Die Temperatur kann z.B. durch kontaktlose Temperaturfühler erfasst werden oder mittelbar durch die Temperatur in der Konditionierungskammer 34 bestimmt werden.

Weitere Einflussmöglichkeiten sind denkbar, von denen hier nur einige Beispiele erwähnt sind. So kann die über die Dosierbehälter 14 zur Verfügung gestellte Auftragsmenge von Beschichtungsmaterial in Abhängigkeit der Oberflächenbeschaffenheit geregelt werden, die z. B. durch Drücke wie den Einspritzdruck oder den Werkzeuginnendruck beeinflusst wird.

Des weiteren ist die Oberflächentemperatur des Teils 10 z. B. wichtig für das Einbringen der zusätzlichen Vemetzungsenergie durch die Aushärtemittel 18, und somit von diesem Parameter abhängig.

Bekannt ist aber z. B. aus dem Spritzgießprozess auch, dass nach einer Unterbrechung und Start des Prozess eine gewisse Zeit (Zyklen) vergeht, bis ein quasi stabiler Zustand erzeugt ist. Bei Kenntnis dieses Veränderungsprozess bis zum quasi stabilen Zustand kann dies ebenso als prozessrelevante Größe in die In-line-Beschichtung einfließen und somit zur Gleichmäßigkeit bzw. zur Ausschussreduzierung beitragen.

Das Verfahren kann so zur Herstellung von komplexen Kunststoffteilen inkl. der nachfolgenden In-line-Oberflächenbehandlung derselben unter Prozessverkettung der Spritzparameter zum Beschichtungsverfahren und rückwirkend vom Ergebnis der Beschichtung auf die Prozessregelung des Spritzgießprozess mit dem Ziel eingesetzt werden, höchste Qualität mit minimalstem Ausschuss und somit höchster Präzision und Kostenminimierung zu realisieren.

### Bezugszeichenliste

- 10: Teil
- 11: Vakuumkammer
- 12: Eingangskammer
- 13: Ausgangskammer
- 14: Dosierbehälter
- 15: Kunststoff-Spritzgießmaschine
- 16: Vakuumpumpe
- 18: Aushärtemittel
- 21,25: Ventil
- 22: Leitung
- 22a: Eintrittspunkt
- 24: Lackbehälter
- 26: Träger
- 30: Ventil
- 31: Belüftungsleitung
- 34: Konditionierungskammer
- 35: Einflussbereich von 40
- 36: Übergabebereich
- 37: Drehtisch
- 38: Übergabestation
- 39: Entnahmebereich
- 40: Steuerung der Lackiereinrichtung
- 50: Steuerung von 15

## Patentansprüche

1. Verfahren zur Herstellung von beschichteten Teilen (10) mit den Schritten:
- Herstellen des Teils in einer Spritzgießmaschine (15) zur Verarbeitung von Kunststoffen und anderer plastifizierbarer Materialien wie pulverige, metallische oder keramische Massen,
- Entnehmen des Teils aus der Spritzgießmaschine (15),
- Erfassen der Spritzgießparameter während der Herstellung des Teils und/oder von Messgrößen des Teils,
- Platzieren des Teils (10) in wenigstens einer Beschichtungskammer einer Einrichtung zur Oberflächenbeschichtung,
- Einbringen der Beschichtung in die Beschichtungskammer und damit einhergehendes Aufbringen der Beschichtung auf das Teil (10) in einem Beschichtungsprozess,
- Entnehmen des beschichteten Teils (10) aus der Beschichtungskammer, **dadurch gekennzeichnet, dass** die Parameter des Beschichtungsprozess in Abhängigkeit der Spritzgießparameter während der Herstellung des Teils (10) und/oder in Abhängigkeit von Messgrößen des Teils geregelt werden und dass umgekehrt die während des und/oder nach dem Beschichtungsprozess erfassten Parameter den Spritzgießprozess zur Herstellung des Teils regeln.

2. Verfahren nach Anspruch 1, **dadurch gekennzeichnet, dass** während und/oder nach der Beschichtung des Teils Messgrößen gebildet werden, die an die Steuerung (50) der Spritzgießmaschine zur Regelung der Spritzgießparameter übergeben werden.

3. Verfahren nach Anspruch 1 oder 2, **dadurch gekennzeichnet, dass** die Beschichtung ein vorzugsweise flüssiger Lack ist.

4. Verfahren nach einem der vorhergehenden Ansprüche, **dadurch gekennzeichnet, dass** die Beschichtungskammer eine Vakuumkammer (11) ist und dass das Teil zyklusabhängig in die Vakuumkammer eingebracht und dort beschichtet und nach Abbau des Vakuums aus der Kammer entnommen wird

5. Verfahren nach einem der vorhergehenden Ansprüche, **dadurch gekennzeichnet, dass** zur Beeinflussung der Oberflächenqualität des Teils (10) wenigstens einer der Spritzgießparameter Massetemperatur, Einspritzgeschwindigkeit, Einspritzdruck, Werkzeugtemperatur, Werkzeuginnendruck, Zykluszeit, Anfahrzeit und Kühlzeit verwendet werden.

6. Verfahren nach einem der vorhergehenden Ansprüche, **dadurch gekennzeichnet, dass** die Teile mit einer Oberflächentemperatur dem Beschichtungsprozess zugeführt werden, die auf Grund der Werkzeugtemperatur und durch Veränderung oder Verzögerung in einer Kühlstrecke zwischen der Spritzgießmaschine und der Einrichtung zur Oberflächenbeschichtung geregelt ist.

7. Verfahren nach einem der vorhergehenden Ansprüche, **dadurch gekennzeichnet, dass** die Auftragsmenge von Beschichtungsmaterial in Abhängigkeit der Oberflächenbeschaffenheit geregelt wird, die aufgrund der Spritzgießparameter bekannt ist.

8. Verfahren nach einem der vorhergehenden Ansprüche, **dadurch gekennzeichnet, dass** der Beschichtungskammer Aushärtemittel (18) zum Einbringen zusätzlicher Vemetzungsenergie zugeordnet werden und dass die Menge an Vernetzungsenergie in Abhängigkeit der Oberflächentemperatur des Teils geregelt wird.

9. Verfahren nach einem der vorhergehenden Ansprüche, **dadurch gekennzeichnet, dass** das Teil (10) nach dem First-in First-out Prinzip der Beschichtungskammer von der Spritzgießmaschine zugeführt wird.

## Claims

1. Method for producing coated parts (10) comprising the following steps:
- producing the part in an injection moulding machine (15) for processing plastics and other plasticisable materials, such as powdered, metal or ceramic masses,
- removing the part from the injection moulding machine (15),
- detecting the injection moulding parameters during the production of the part and/or measured parameters of the part,
- placing the part (10) in at least one coating chamber of a facility for surface coating,
- introducing the coating into the coating chamber and applying the coating in a concomitant manner to the part (10) in a coating process,
- removing the coated part (10) from the coating chamber,
**characterised in that** the parameters of the coating process are controlled depending on the injection moulding parameters during the production of the part (10) and/or depending on measured parameters of the part, and **in that**, inversely, the parameters detected during and/or after the coating process control the injection moulding process for production of the part.

2. Method according to claim 1, **characterised in that** measured parameters are formed during and/or after the coating of the part and are transferred to the controller (50) of the injection moulding machine for control of the injection moulding parameters.

3. Method according to claim 1 or 2, **characterised in that** the coating is a preferably liquid lacquer.

4. Method according to any one of the preceding claims, **characterised in that** the coating chamber is a vacuum chamber (11), and **in that** the part is introduced into the vacuum chamber in a cyclical manner and is coated there and is removed from the chamber following depletion of the vacuum.

5. Method according to any one of the preceding claims, **characterised in that** at least one of the following injection moulding parameters: mass temperature, injection speed, injection pressure, mould temperature, mould cavity pressure, cycle time, start-up time, and cooling time is used in order to influence the surface quality of the part (10).

6. Method according to any one of the preceding claims, **characterised in that** the parts are supplied to the coating process with a surface temperature that is controlled on the basis of the mould temperature and by alteration or delay in a cooling section between the injection moulding machine and the facility for surface coating.

7. Method according to any one of the preceding claims, **characterised in that** the amount of coating material to be applied is controlled depending on the surface condition, which is known on the basis of the injection moulding parameters.

8. Method according to any one of the preceding claims, **characterised in that** the coating chamber is associated with curing means (18) for introducing additional cross-linking energy, and **in that** the amount of cross-linking energy is controlled depending on the surface temperature of the part.

9. Method according to any one of the preceding claims, **characterised in that** the part (10) is supplied to the coating chamber from the injection moulding machine in accordance with the first-in first-out principle.

## Revendications

1. Procédé de fabrication de pièces revêtues (10) comportant les étapes consistant à :
- fabriquer une pièce dans une machine de moulage par injection (15) pour la préparation de matières plastiques et d'autres matériaux plastifiables comme des masses pulvérulentes, métalliques ou céramiques,
- retirer la pièce de la machine de moulage par injection (15),
- saisir les paramètres du moulage par injection pendant la fabrication de la pièce et/ou des mesures de la pièce,
- placer la pièce (10) dans au moins une chambre de revêtement d'un dispositif de revêtement de surface,
- introduction du revêtement dans la chambre de revêtement et application concomitante du revêtement sur la pièce (10) au cours d'un processus de revêtement,
- retirer la pièce revêtue (10) de la chambre de revêtement,
**caractérisé en ce que** les paramètres du processus de revêtement sont réglés en fonction des paramètres de moulage par injection pendant la fabrication de la pièce (10) et/ou en fonction des mesures de la pièce et **en ce que**, inversement, les paramètres saisis pendant et/ou après le processus de revêtement règlent le processus de moulage par injection pour la fabrication de la pièce.

2. Procédé selon la revendication 1, **caractérisé en ce que** pendant et/ou après le revêtement de la pièce, des mesures sont réalisées, lesquelles sont transmises au dispositif de commande (50) de la machine à mouler par injection en vue du réglage des paramètres de moulage par injection.

3. Procédé selon la revendication 1 ou 2, **caractérisé en ce que** le revêtement est une laque de préférence fluide.

4. Procédé selon l'une des revendications précédentes, **caractérisé en ce que** la chambre de revêtement est une chambre à vide (11) et **en ce que** la pièce est introduite dans la chambre à vide en fonction du cycle et y est revêtue et en est retirée après suppression du vide dans la chambre.

5. Procédé selon l'une des revendications précédentes, **caractérisé en ce que** pour influer sur la qualité de surface de la pièce (10), on utiliser au moins l'un des paramètres de moulage par injection parmi la température de la masse, la vitesse d'injection, la pression d'injection, la température de l'outil, la pression intérieure de l'outil, la durée du cycle, la durée du trajet et la durée du refroidissement.

6. Procédé selon l'une des revendications précédentes, **caractérisé en ce que** les pièces sont amenées au processus de revêtement avec une température de surface qui est réglée sur la base de la température de l'outil et par modification ou retardement dans une zone de refroidissement entre la machine de moulage par injection et le dispositif de revêtement de surface.

7. Procédé selon l'une des revendications précédentes, **caractérisé en ce que** la quantité de matériau de revêtement appliquée est réglée en fonction de l'état de surface, lequel est connu à partir des paramètres de moulage par injection.

8. Procédé selon l'une des revendications précédentes, **caractérisé en ce que** des moyens de durcissement (18) sont associés à la chambre de revêtement pour l'apport d'énergie supplémentaire de réticulation et **en ce que** la quantité d'énergie de réticulation est réglée en fonction de la température de surface de la pièce.

9. Procédé selon l'une des revendications précédentes, **caractérisé en ce que** la pièce (10) est amenée selon le principe du premier entré - premier sorti à la chambre de revêtement de la machine de moulage par injection.
